# EUROPÄISCHE PATENTANMELDUNG

(11) **EP 4 722 812 A2**
(43) Veröffentlichungstag der Anmeldung: **08.04.2026**
(21) Anmeldenummer: 26154482.9
(22) Anmeldetag: 24.05.2016
(51) Int. Cl.: G03F 7/027

(54) **VERFAHREN ZUR HERSTELLUNG EINER FLEXODRUCKFORM AUS EINEM DIGITAL BEBILDERBAREN, FOTOPOLYMERISIERBAREN FLEXODRUCKELEMENT MIT INTEGRALER BARRIERESCHICHT**

(30) Priorität: 28.05.2015 EP 15169554
(62) Teilanmeldung aus: 19209908.3
(71) Anmelder: XSYS Germany GmbH, 77731 Willstätt (DE)
(72) Erfinder: Beyer, Matthias, 69469 Weinheim (DE); Becker, Armin, 67259 Großniedesheim (DE)
(74) Vertreter: Arnold & Siedsma

(57) **Zusammenfassung**

Die Erfindung betrifft ein Verfahren zur Herstellung einer Flexodruckform aus einem digital bebilderbaren, fotopolymerisierbaren Flexodruckelement enthaltend in der genannten Reihenfolge übereinander angeordnet mindestens einen dimensionsstabilen Träger (A), mindestens eine fotopolymerisierbare, reliefbildende Schicht (B), eine für UVA-Licht transparente, Sauerstoff-sperrende Barriereschicht (C), eine laserablatierbare Maskenschicht (D) sowie eine abziehbare Deckfolie (E), wobei das Verfahren mindestens die Schritte
(i) Abziehen der Deckfolie (E),
(ii) Einschreiben einer Maske in die laserablatierbare Maskenschicht (D) mithilfe eines IR-Lasers,
(iii) Belichten des bebilderten Flexodruckelements mit UVA-Licht durch die gebildete Maske hindurch,
(iv) Entfernen der Reste der laserablatierbaren Maskenschicht (D), der Barriereschicht (C) sowie der nicht polymerisierten Anteile der reliefbildenden Schicht (B), sowie
(v) optional Nachbelichtung der getrockneten Flexodruckplatte mit UVA- und/oder UVC-Licht
umfasst und wobei die Schichten (B), (C) und (D) in einem organischen Lösemittel löslich oder dispergierbar sind, und die Barriereschicht (C) mindestens ein Sauerstoff-sperrendes Bindemittel und eine oligomere oder polymere basische Haftkomponente enthält und dass das mindestens teilweise Entfernen gemäß Schritt (iv) durch Erwärmen und Entfernen der nicht belichteten Bereiche mittels eines Entwicklungsmaterials erfolgt.

## Beschreibung

Die vorliegende Erfindung betrifft ein Verfahren zur Herstellung einer Flexodruckform aus einem digital bebilderbaren Flexodruckelement, welches eine Trägerfolie, eine organisch lösliche, fotopolymerisierbare Schicht, eine organisch lösliche Barriereschicht für Sauerstoff, eine organisch lösliche, laserablatierbare Maskenschicht sowie eine Deckfolie umfasst.

### Stand der Technik

Digital bebilderbare Flexodruckplatten sind prinzipiell bekannt. Sie umfassen mindestens eine dimensionsstabile Trägerfolie, eine fotopolymerisierbare Schicht sowie eine digital bebilderbare Schicht. Bei der digital bebilderbaren Schicht kann es sich beispielsweise um eine laserablatierbare Schicht, um eine mittels Ink-Jet-Drucker beschreibbare Schicht oder um eine thermographische Schicht handeln, wobei laserablatierbare Schichten am gebräuchlichsten sind.

Laserablatierbare Schichten, auch LAMS (laserablatierbare Maskenschichten) genannt, sind für die Wellenlänge des aktinischen Lichtes opak und umfassen üblicherweise ein Bindemittel sowie mindestens einen IR-Absorber wie beispielsweise Ruß. Ruß bewirkt auch, dass die Schicht opak ist. In die laserablatierbare Schicht kann mittels eines IR-Lasers eine Maske eingeschrieben werden, d.h. die Schicht wird an den Stellen, an denen sie vom Laserstrahl getroffen wird, zersetzt und die darunter angeordnete fotopolymerisierbare Schicht wird freigelegt. Die laserablatierbare Maskenschicht kann unmittelbar auf die fotopolymerisierbare Schicht aufgebracht werden oder zwischen der fotopolymerisierbaren Schicht und der laserablatierbaren Maskenschicht können sich noch weitere Schichten befinden, beispielsweise eine Sperrschicht. Beispiele für die Bebilderung von Flexodruckelementen mit IR-ablativen Masken sind beispielsweise in US 5,262,275 oder EP-A 1 069 475 offenbart.

Die Herstellung von Flexodruckformen ausgehend von fotopolymerisierbaren, digital bebilderbaren Flexodruckelementen erfolgt wie folgt: Nach dem Einschreiben einer Maske in die digital bebilderbare Schicht wird das Flexodruckelement durch die Maske hindurch mit UVA-Strahlung belichtet. Die fotopolymerisierbare Schicht polymerisiert in den von der Maske nicht mehr abgedeckten Bereichen, während in den abgedeckten Bereichen keine Polymerisation erfolgt. Nach der Belichtung werden die Reste der Maske sowie die nicht polymerisierten Anteile der fotopolymerisierbaren Schicht entfernt. Dies kann unter Verwendung von einem oder mehreren Lösemitteln oder auch thermisch erfolgen. Bei Verwendung von organischen Lösemitteln schließt sich ein Trockenschritt an, und üblicherweise wird die erhaltene Flexodruckform noch nachbehandelt, beispielsweise durch Belichten mit UVA- und/oder UVC-Licht. Bei digital bebilderbaren Flexodruckelementen erfolgt die Hauptbelichtung mittels UVA-Strahlung üblicherweise in Gegenwart von Luftsauerstoff.

Es ist bekannt, dass bei der Hauptbelichtung die Anwesenheit von Sauerstoff einen ganz erheblichen Einfluss auf die Form der druckenden Reliefelemente hat, ganz besonders auf die Form feiner Rasterelemente. Molekularer Sauerstoff ist bekanntlich ein Diradikal und kann daher mit anderen Radikalen reagieren. Die Anwesenheit von molekularem Sauerstoff während der durch UV-Licht ausgelösten radikalischen Polymerisation führt dazu, dass der Sauerstoff die Radikalkettenreaktion an der Oberfläche der fotopolymerisierbaren Schicht unterbricht und somit, dass die Oberfläche der Reliefelemente nicht mehr ausreichend polymerisiert. Weiter unterhalb der Oberfläche gelegene Bereiche der fotopolymerisierbaren Schicht werden weniger beeinflusst. Im Zuge der Entwicklung der Schicht nach der Polymerisation werden die nicht ausreichend polymerisierten Schichten ebenfalls entfernt. Die Reliefelemente sind somit kleiner als sie eigentlich sein sollten und weisen abgerundete Ecken auf. Dieser Effekt ist beispielsweise anschaulich in EP 2 128 702 A1, Seite 15, Figur 1 dargestellt.

Grundsätzlich sollte der störende Einfluss von Sauerstoff bei der Belichtung von Flexodruckelementen ausgeschaltet werden, damit die vorgesehenen Reliefelemente bis zur Oberfläche vollständig polymerisiert werden, und somit feinere Details auf der Platte abgebildet werden können. Ferner wäre es wünschenswert die Oberflächenbeschaffenheit des Flexodruckklischees gezielt beeinflussen zu können, um die Farbübertragung und das Farbliegeverhalten zu verbessern.

Es ist daher vorgeschlagen worden, die fotopolymerisierbare Schicht während der Hauptbelichtung vor Sauerstoff zu schützen. So ist es prinzipiell möglich, unter Schutzgas (siehe beispielsweise US 8,241,835) oder unter Verwendung eines Vakuumrahmens zu belichten, aber diese Vorgehensweise ist mit zusätzlichem apparativem Aufwand verbunden und wird daher üblicherweise vermieden.

Alternativ wurde vorgeschlagen, die Belichtung der Flexodruckplatten mit UVA-Licht mit hoher Leistung, beispielsweise mittels UV-LED's, durchzuführen (siehe beispielsweise EP 2 596 404). Auf diese Art und Weise werden in kurzer Zeiteinheit sehr viel mehr Radikale gebildet und der Einfluss des störenden Sauerstoffs wird überfahren. Aber auch diese Vorgehensweise ist mit zusätzlichem apparativem Aufbau und höheren Kosten bei der Verarbeitung der Flexodruckplatten verbunden.

Ferner wurde vorgeschlagen, die Nachdiffusion des Sauerstoffs durch das Auflaminieren einer Sperrschicht auf das bereits bebilderte Flexodruckelement zu unterbinden. Beispielsweise beschreibt die US 2012/0164584 das Auflaminieren von Barriereschichten nach der Bebilderung mittels Laser und vor der flächigen UVA-Belichtung. Alternativ wird auch das Auftragen einer Ölschicht erwähnt.

Oder es wurde vorgeschlagen, die Flexodruckplatten durch einen separat hergestellten Maskenfilm zu belichten. WO 2005/101130 A1 offenbart einen mehrschichtigen Maskenfilm zur Herstellung von Flexodruckformen. Der Maskenfilm wird mit einem Laser bebildert und anschließend mit der gelaserten Schichtseite auf das Flexodruckelement auflaminiert. Die Trägerschicht des Maskenfilms fungiert als Sperre gegenüber Sauerstoff bei der nachfolgenden Belichtung mit UVA-Strahlung.

Laminierverfahren, wie das nachträgliche Aufbringen einer Sauerstoff sperrenden Folie oder das nachtägliche Aufbringen eines zuvor belichteten Maskenfilms, sind aber nicht zu empfehlen, da bei jeder Laminierung Fehlstellen entstehen können, beispielsweise durch Einschluss von Staubpartikeln oder Einschluss von Luft. Jede kleinste Fehlstelle macht das Flexoklischee aber unbrauchbar. Ferner ist das Laminieren bzw. das nachträgliche Aufbringen von Barriereschichten ein zusätzlicher Arbeitsschritt im Zuge der Verarbeitung des Flexodruckelements und von daher beim Anwender äußerst unerwünscht.

Das Ziel muss es daher sein, die Barriereschicht als integralen Bestandteil in die Flexodruckplatte einzubauen. Flexodruckplatten mit eingebauter Barriereschicht sind ebenfalls bekannt.

US 5,262,275 offenbart beispielsweise Flexodruckelemente, welche einen Träger, eine fotopolymerisierbare Schicht, eine darauf aufgebrachte Barriereschicht und eine darauf aufgebrachte laserablatierbare Maskenschicht umfassen. Die Barriereschicht soll einerseits die Migration von Komponenten, beispielsweise von Monomeren aus der fotopolymerisierbaren Schicht in die laserablatierbare Schicht verhindern und andererseits die fotopolymerisierbare Schicht vor atmosphärischem Sauerstoff während der Belichtung des Flexodruckelements schützen. Als Materialien für die Barriereschichten werden Polyamide, Polyvinylalkohol, Hydroxyalkylcellulose, Ethylen-Vinylacetat-Copolymere, amphotere Interpolymere und Kombinationen davon genannt. Die Dicke der Barriereschicht beträgt 0,25 µm bis 76 µm, bevorzugt 0,38 bis 64 µm.

Vergleichbar aufgebaute Flexodruckelemente werden in der WO 2012/145111 A1 beschrieben. Als Materialien für die Barriereschicht werden Polyamide, Polyvinylalkohol, Hydroxyalkylcellulose, Polyvinylpyrrolidon, Ethylen-Vinylacetat-Copolymere, amphotere Interpolymere, Celluloseacetatbutyrat, Alkylcellullose, Butyral, cyclische Kautschuke oder Kombinationen davon vorgeschlagen. Zusätzlich soll die Barriereschicht einen Diffusionskoeffizienten für O₂ von weniger als 6,9*10⁻⁹ m²/s und eine optische Transparenz von mindestens 50 %, bevorzugt mindestens 75 % aufweisen. Die Schichtdicke der Barriereschicht beträgt 1 bis 100 µm, bevorzugt 1 bis 20 µm.

In der US 8,492,074 B2 werden digital bebilderbare Flexodruckelemente mit einer Barriereschicht aus mindestens zwei verschiedenen Harzen beschrieben. Die Barriereschicht wird entweder nach der Bebilderung auflaminiert oder sie kann in der Flexodruckplatte bereits als integraler Bestandteil vorhanden sein. Die Harze der Barriereschicht werden bevorzugt aus der Gruppe von Polyvinylpyrrolidon, Shellack, Polyvinylbutyral, Polyvinylidenchlorid oder Vinylchloridcopolymeren ausgewählt.

Ferner sind weitere digital bebilderbare Flexodruckplatten mit integraler Barriereschicht beschrieben, deren fotopolymerisierbare Schicht in Wasser oder wässrigen Lösungen ausgewaschen werden kann und die daher bevorzugt wasserlösliche oder zumindest wässrig entwickelbare Polymere als Bindemittel für die Barriereschicht und für die laserablatierbare Maskenschicht enthalten: So beschreibt EP 2284612 Barriereschichten aus wasserlöslichen Polyamiden, Polyvinylalkohol, Polyacrylsäure, Polyethylenoxid, Cellulose und Cellulosederivaten. EP 1156368 beschreibt Barriereschichten aus alkalilöslichen Cellulosederivaten mit Weichmachern zur Flexibilisierung der Schicht. Allerdings sind wasserauswaschbare Flexodruckplatten für den hochqualitativen Flexodruck nur bedingt einsetzbar, da sie in den polaren Farblösemitteln quellen und keine konstante Druckqualität ermöglichen.

Schließlich beschreibt die WO 2015/040094 Flexodruckplatten, die eine wasserlösliche laserablatierbare Maskenschicht und eine wasserlösliche Barriereschicht auf einer in organischen Lösemitteln löslichen fotopolymerisierbaren Schicht aufweisen. Als Material für die Barriereschicht werden teilverseifte Polyvinylacetat-Copolymere bevorzugt. Allerdings müssen diese Flexodruckplatten in einem zweistufigen Verfahren ausgewaschen werden, was wiederum höhere Kosten mit sich bringt.

Ein generelles Problem von mehrschichtig aufgebauten Flexodruckplatten ist die benötigte abgestufte Haftung zwischen den einzelnen Schichten. Die Deckfolie muss einerseits sicher auf der laserablatierbaren Maskenschicht verankert sein, denn während des Transportes der Platte oder beim Zuschneiden der Platte darf sich die Deckfolie nicht vom Rand der Platte ablösen. Vor der Bebilderung mittels Laser muss die Deckfolie aber entfernt werden. Das Abziehen muss auch bei großen Formaten ohne besonderen Kraftaufwand möglich sein. Beim Abziehen der Deckfolie müssen die laserablatierbare Maskenschicht und die Barriereschicht vollständig auf der Platte verbleiben. Diese beiden Schichten müssen daher sehr gut aneinander haften und der Verbund beider Schichten muss wiederum sehr gut auf der fotopolymerisierbaren Schicht haften. Weiterhin muss die fotopolymerisierbare Schicht stets haftfest mit der dimensionsstabilen Trägerfolie verbunden bleiben. Insbesondere bei einem Schichtaufbau aus unpolaren, in organischen Lösemitteln löslichen Schichten ist es schwierig, die Haftung zwischen den einzelnen Schichten des Schichtverbunds in der beschriebenen Weise gezielt einzustellen. Auf dieses Problem und mögliche Lösungen des Problems wird in keiner der zitierten Patentschriften hingewiesen.

Es wird ein Verfahren zur Herstellung einer Flexodruckform vorgeschlagen. Die Flexodruckform wird hergestellt aus einem digital bebilderbaren, fotopolymerisierbaren Flexodruckelement enthaltend in der genannten Reihenfolge übereinander angeordnet mindestens
(A) einen dimensionsstabilen Träger,
(B) mindestens eine fotopolymerisierbare, reliefbildende Schicht mit einer Schichtdicke von 300 bis 7000 µm, umfassend mindestens ein elastomeres Bindemittel, ein ethylenisch ungesättigtes Monomer sowie einen Fotoinitiator oder ein Fotoinitiatorsystem,
(C) eine für UVA-Licht transparente, Sauerstoff-sperrende Barriereschicht mit einer Schichtdicke von 0,3 bis 5 µm,
(D) eine laserablatierbare Maskenschicht mit einer Schichtdicke von 0,3 bis 5 µm, umfassend mindestens ein elastomeres Bindemittel und ein UV/VIS-Licht absorbierendes Material, sowie
(E) eine abziehbare Deckfolie.

Das Verfahren umfasst die Schritte
(i) Abziehen der Deckfolie (E),
(ii) Einschreiben einer Maske in die laserablatierbare Maskenschicht (D) mithilfe eines IR-Lasers,
(iii) Belichten des bebilderten Flexodruckelements mit UVA-Licht durch die gebildete Maske hindurch,
(iv) Entfernen der Reste der laserablatierbaren Maskenschicht (D), der Barriereschicht (C) sowie der nicht polymerisierten Anteile der reliefbildenden Schicht (B), sowie
(v) optional Nachbelichtung der getrockneten Flexodruckplatte mit UVA- und/oder UVC-Licht.

Ferner ist bei dem Verfahren vorgesehen, dass die Schichten (B), (C) und (D) in einem organischen Lösemittel löslich oder dispergierbar sind, und die Barriereschicht (C) mindestens ein Sauerstoff-sperrendes Bindemittel und eine oligomere oder polymere basische Haftkomponente enthält und dass das mindestens teilweise Entfernen gemäß Schritt (iv) durch Erwärmen und Abziehen der nicht belichteten Bereiche mittels eines Entwicklungsmaterials erfolgt.

Bei dem Verfahren wird ein digital bebilderbares, fotopolymerisierbares Flexodruckelement zur Herstellung von Flexodruckformen verwendet, umfassend in der genannten Reihenfolge übereinander angeordnet mindestens
(A) einen dimensionsstabilen Träger,
(B) mindestens eine fotopolymerisierbare, reliefbildende Schicht mit einer Schichtdicke von 300 bis 6000 µm, umfassend mindestens ein elastomeres Bindemittel, ein ethylenisch ungesättigtes Monomer sowie einen Fotoinitiator oder ein Fotoinitiatorsystem,
(C) eine für UVA-Licht transparente, Sauerstoff-sperrende Barriereschicht mit einer Schichtdicke von 0,3 bis 5 µm,
(D) eine laserablatierbare Maskenschicht mit einer Schichtdicke von 0,3 bis 5 µm, umfassend mindestens ein elastomeres Bindemittel und ein UV/VIS-Licht absorbierendes Material, sowie
(E) eine abziehbare Deckfolie,
wobei
- die Schichten (B), (C) und (D) in einem organischen Lösemittel löslich oder dispergierbar sind, und
- die Barriereschicht (C) mindestens ein Sauerstoff-sperrendes Bindemittel und eine oligomere oder polymere basische Haftkomponente enthält.

Im Folgenden werden die Begriffe "Flexodruckform" oder "Klischee" für eine bereits vernetzte, druckfertige Druckform verwendet. Dier Begriffe "Flexodruckelement" oder "Flexodruckplatte" werden in üblicher Art und Weise für das fotopolymerisierbare Ausgangsmaterial verwendet, welches zur Herstellung von Flexodruckformen verwendet wird.

Die mit dem erfindungsgemäßen Verfahren bearbeiteten bebilderbaren fotopolymerisierbaren Flexodruckelemente bzw. Flexodruckplatten umfassen mindestens die folgenden übereinander angebrachten Schichten: Einen dimensionsstabilen Träger (A), eine reliefbildende Schicht (B), eine Barriereschicht (C), eine laserablatierbare Maskenschicht (D) und eine Deckfolie (E). Selbstverständlich können noch weitere Schichten, z.B. weitere Haftschichten, vorhanden sein.

Kern der Erfindung ist die Zusammensetzung der Barriereschicht (C), die mindestens ein gegen Sauerstoff sperrendes, in organischen Lösungsmitteln lösliches Bindemittel als Hauptkomponente und eine oligomere oder polymere basische Haftkomponente als Nebenbestandteil enthält. Die Zusammensetzung dieser Barriereschicht ist für die Haftung des Schichtverbundes entscheidend. Die erfindungsgemäßen Flexodruckplatten können sicher gehandhabt und mit marktüblichen Lasern und Belichtungsgeräten verarbeitet werden. Ein weiteres Kennzeichen der Erfindung ist, dass die Schichten (B), (C) und (D) in organischen Lösungsmitteln löslich oder dispergierbar sind. Die erfindungsgemäßen Flexodruckplatten können mit marktüblichen Lösungsmitteln für Flexoplatten in marktüblichen Auswaschgeräten, bei üblichen Verarbeitungszeiten und bis zu üblichen Feststoffgehalten der Lösungsmittel verarbeitet werden. Marktübliche Lösungsmittel für Flexoplatten sind beispielsweise Flexosol^{®} (Dupont) oder nylosolv^{®} (Flint Group). Diese Lösungsmittel enthalten als Hauptkomponente ein unpolares Kohlenwasserstofflösungsmittel und als Nebenkomponente einen mäßig polaren Alkohol.

Darüber hinaus zeigen die erfindungsgemäßen Flexodruckplatten die gewünschte hohe Auflösung. In einer weiteren Ausführungsform der Erfindung enthält die Barriereschicht noch einen Füllstoff, durch den die Oberflächentopographie der Flexodruckklischees gezielt eingestellt und die Farbübertragung der Flexodruccklischees signifikant verbessert werden kann.

Die Zusammensetzung der einzelnen Schichten wird im Folgenden näher beschrieben.

### Dimensionsstabiler Träger (A)

Das Flexodruckelement umfasst in prinzipiell bekannter Art und Weise einen dimensionsstabilen Träger. Im Falle von Flexodruckplatten werden üblicherweise dimensionsstabile Trägerfolien eingesetzt, welche üblicherweise eine Dicke von 50 bis 300 µm aufweisen. Bei dem Material der Trägerfolie kann es sich beispielweise um Stahl oder Aluminium oder um Kunststoffe wie beispielsweise Polyethylenterephthalat, Polybutylenterephthalat, Polyethylennaphthalat oder Polycarbonat handeln. Geeignet sind insbesondere PET-Folien mit einer Dicke von 100 bis 200 µm.

Die dimensionsstabilen Träger (A) können optional mit üblichen, haftvermittelnden Schichten behandelt sein.

### Fotopolymerisierbare, reliefbildende Schicht (B)

Die Flexodruckplatte umfasst mindestens eine fotopolymerisierbare, reliefbildende Schicht (B). Die fotopolymerisierbare reliefbildende Schicht kann unmittelbar auf dem Träger aufgebracht sein. Zwischen dem Träger und der reliefbildenden Schicht können sich aber auch noch andere Schichten befinden, wie beispielsweise Haftschichten oder elastische oder kompressible Unterschichten.

Die fotopolymerisierbare, reliefbildende Schicht (B) umfasst mindestens ein elastomeres Bindemittel, eine ethylenisch ungesättigte Verbindung, einen Fotoinitiator oder ein Fotoinitiatorsystem sowie optional eine oder mehrere weitere Komponenten, beispielsweise Weichmacher, Verarbeitungshilfsmittel, Farbstoffe und UV-Absorber.

Elastomere Bindemittel zur Herstellung von Flexodruckelementen sind dem Fachmann bekannt. Als Beispiele seien Styrol-Dien-Blockcopolymere, Naturkautschuk, Polybutadien, Polyisopren, Styrol-Butadien-Kautschuk, Nitril-Butadien-Kautschuk, Butyl-Kautschuk, Styrol-Isopren-Kautschuk, Styrol-Butadien-Isopren-Kautschuk, Polynorbornen-Kautschuk oder Ethylen-Propylen-Dien-Kautschuk (EPDM) genannt. Bevorzugt werden hydrophobe Bindemittel eingesetzt. Derartige Bindemittel sind in organischen Lösemitteln löslich.

Bevorzugt handelt es sich bei dem Elastomer um ein thermoplastisch elastomeres Blockcopolymer aus Alkenylaromaten und 1,3-Dienen. Bei den Blockcopolymeren kann es sich sowohl um lineare, verzweigte oder radiale Blockcopolymere handeln. Üblicherweise handelt es sich um Dreiblock-Copolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblock-Copolymere enthalten häufig gewisse Anteile an Zweiblock-Copolymeren. Die Dieneinheiten können 1,2- oder 1,4-verknüpft sein. Es können sowohl Blockcopolymere vom Styrol-Butadien- oder vom Styrol-Isopren-Typ, als auch vom Styrol-Butadien-Isopren-Typ eingesetzt werden. Sie sind beispielsweise unter dem Namen Kraton^{®} im Handel erhältlich. Weiterhin einsetzbar sind auch thermoplastisch elastomere Blockcopolymere mit Endblöcken aus Styrol und einem statistischen Styrol-Butadien-Mittelblock, die unter dem Namen Styroflex^{®} erhältlich sind. Die Blockcopolymere können auch ganz oder teilweise hydriert sein, wie beispielsweise in SEBS-Kautschuken. Bevorzugte elastomere Bindemittel sind Dreiblock-Copolymere vom Typ A-B-A oder radiale Blockcopolymere vom Typ (AB)n, worin A Styrol und B ein Dien sind, sowie statistische Copolymere und Random-Copolymere aus Styrol und einem Dien.

Die Gesamtmenge an elastomeren Bindemitteln beträgt im Falle der reliefbildenden Schicht (B) üblicherweise 40 bis 90 Gew.-% bezüglich der Summe aller Bestandteile der reliefbildenden Schicht, bevorzugt 40 bis 80 Gew.-% und besonders bevorzugt 45 bis 75 Gew.-%.

Die fotopolymerisierbare reliefbildende Schicht (B) umfasst weiterhin in bekannter Art und Weise mindestens eine ethylenisch ungesättigte Verbindung, die mit den Bindemitteln verträglich ist. Geeignete Verbindungen weisen mindestens eine ethylenisch ungesättigte Doppelbindung auf und sind polymerisierbar. Diese werden daher nachfolgend als Monomere bezeichnet. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und - estern, Ester der Fumar- oder Maleinsäure, Vinylether, Vinylester oder Allylverbindungen erwiesen. Die Menge an Monomeren in der fotopolymerisierbaren reliefbildenden Schicht (B) beträgt im Regelfalle nicht mehr als 20 Gew.-% bzgl. der Menge aller Bestandteile der fotopolymerisierbaren reliefbildenden Schicht (B), im Allgemeinen beträgt sie von 3 bis 15 Gew.-%.

Die fotopolymerisierbare reliefbildende Schicht (B) umfasst weiterhin in bekannter Art und Weise mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acrylarylphosphinsäureester, α-Hydroxyketone, Mehrkernchinone oder Benzophenone. Die Menge an Fotoinitiator in der reliefbildenden Schicht beträgt in der Regel bis 10 Gew.-% bezüglich der Menge aller Bestandteile der reliefbildenden Schicht. Bevorzugt ist eine Menge von 2 bis 8 Gew.-%, besonders bevorzugt von 3 bis 6 Gew.-%. Der oder die Fotoinitiatoren sollten dabei sehr gut in der reliefbildenden Schicht löslich sein und nicht zur Kristallisation neigen.

Die reliefbildende Schicht (B) kann Weichmacher enthalten. Beispiele für geeignete Weichmacher sind modifizierte und unmodifizierte Naturöle und -harze, wie hochsiedende paraffinische, naphthenische oder aromatische Mineralöle, synthetische Oligomere oder Harze wie Oligostyrol, hochsiedende Ester, oligomere Styrol-Butadien-Copolymere, oligomere Methylstyrolcopolymere, flüssige Oligobutadiene, flüssige Oligoisoprene oder flüssige oligomere AcrylnitrilButadien-Copolymere oder oligomere Ethylen-Propylen-Dien-Copolymere. Bevorzugt sind Polybutadienöle, insbesondere solche mit einem Molekulargewicht von 500 bis 5000 g/mol, hochsiedende aliphatische Ester und Mineralöle. Es können auch Gemische verschiedener Weichmacher eingesetzt werden. Die Menge der optionalen Weichmacher wird vom Fachmann je nach den gewünschten Eigenschaften der Schicht bestimmt. Sie beträgt im Allgemeinen 0 bis 50 Gew.-%, bevorzugt 0 bis 40 Gew.-% der Summe aller Bestandteile der fotopolymerisierbaren reliefbildende Schicht (B).

Die reliefbildende Schicht (B) kann darüber hinaus weitere funktionelle Zusätze enthalten, beispielsweise, wie in US 8,808,968 beschrieben, geringer Mengen von Phosphiten, Phosphinen, Thioethern und von aminofunktionellen Verbindungen. Dadurch kann der störende Einfluss des Luftsauerstoffes, der sich noch in der Schicht befindet, ausgeschaltet werden und eine noch höhere Auflösung erhalten werden.

Weiterhin kann die reliefbildende Schicht (B) grenzflächenaktive Substanzen wie hydrophobe Wachse oder silikonisierte oder perfluorierte Verbindungen enthalten, wie in US 8,114,566 beschrieben. Diese Substanzen wandern während der Trocknung der Flexodruckklischees aus der Reliefschicht an die Oberfläche, wirken gegenüber der Druckfarbe abstoßend und bewirken im Druckprozess, dass feine Raster weniger verschmutzen und die Druckklischees weniger häufig gereinigt werden müssen.

Eine wesentliche Eigenschaft der reliefbildenden (B) Schicht ist, dass sie in den gängigen, kommerziell erhältlichen Flexoauswaschmitteln löslich ist. Kommerziell verfügbare Auswaschmittel für Flexodruckplatten sind beispielsweise nylosolv^{®} von Flint Group oder Flexosol^{®} von Dupont. Diese Auswaschmittel bestehen aus einem oder mehreren unpolaren Kohlenwasserstofflösungsmitteln als Hauptbestandteil und einem mäßig polaren Alkohol, beispielsweise n-Pentanol, Cyclohexanol, Ethylhexanol oder Heptylalkoholen, als Nebenbestandteil. Die reliefbildende Schicht (B) kann in diesen Auswaschmitteln in üblichen Zeiten verarbeitet werden. Bis zu einem Feststoffanteil von mindestens 5 Gew.-% werden dabei keine Verschmutzungen der Auswaschgeräte und kein Absetzen von Feststoffen in der Auswaschlösung beobachtet.

Die Dicke der reliefbildenden Schicht (B) beträgt im Allgemeinen 0,1 bis 7 mm, bevorzugt 0,5 bis 4 mm und besonders bevorzugt 0,7 bis 2,5 mm. Das Flexodruckelement kann auch mehrere in organischen Lösemitteln lösliche oder dispergierbare, fotopolymerisierbare, reliefbildende Schichten übereinander umfassen. Flexodruckelemente mit einem mehrschichtigen Aufbau der fotopolymerisierbaren, reliefbildenden Schicht sind dem Fachmann ebenfalls bekannt.

### Barriereschicht für Sauerstoff (C)

Auf die fotopolymerisierbare, reliefbildende Schicht (B) ist eine in organischen Lösemitteln lösliche oder dispergierbare, für UVA-Licht transparente Barriereschicht für Sauerstoff aufgebracht.

Wie die reliefbildende Schicht (B) ist auch die Barriereschicht für Sauerstoff (C) in den gängigen, kommerziell erhältlichen Flexoauswaschmitteln löslich. Insbesondere ergibt sich durch das Vorhandensein der Barriereschicht keine wesentliche Verlängerung der Auswaschzeit. Die Verlängerung der Auswaschzeit im direkten Vergleich zu einer Flexodruckplatte ohne Barriereschicht beträgt maximal 10%. Bis zu einem Feststoffanteil von mindestens 5 Gew.-% werden keine Verschmutzungen der Auswaschgeräte und kein Absetzen von Feststoffen in der Auswaschlösung beobachtet.

Der Begriff "für UVA-Licht transparent" schließt selbstverständlich nicht aus, dass gewisse Anteile des UVA-Lichts absorbiert werden können. Es ist aber in jedem Fall gewährleistet, dass bei flächiger UVA-Belichtung des Flexodruckelements die Polymerisation der reliefbildenden Schicht (B) möglich ist.

Die Barriereschicht (C) hat die wesentliche Aufgabe, die Nachdiffusion von Sauerstoff in die reliefbildende Schicht (B) während der vollflächigen Belichtung des Flexodruckelements zu verhindern. Die Sauerstoffdurchlässigkeit der Barriereschicht ist im Allgemeinen kleiner als 1000, bevorzugt kleiner als 500 (cm³ x 100 µm)/(m² x d x bar).

Die Barriereschicht (C) umfasst mindestens ein gegen Sauerstoff sperrendes Bindemittel und eine oligomere oder polymere basische Haftkomponente. Eine weitere Anforderung an das Bindemittel der Barriereschicht ergibt sich aus der Verarbeitung der Flexodruckplatte. Bei der Verarbeitung der Flexodruckplatte zum Flexodruckklischee wird diese zunächst mittels IR-Laser bebildert. Dies erfolgt in der Regel mit Laserapparaturen, welche eine rotierende Trommel zur Aufnahme der Flexodruckplatte umfassen. Bei der Montage wird die Flexodruckplatte gebogen und die Oberfläche dabei gedehnt. Die anschließende flächige Belichtung mit UVA-Licht erfolgt im Regelfalle unter Verwendung von Flachbettbelichtern, so dass das Flexodruckelement nach dem Bebildern wieder gerade gebogen wird. Die Barriereschicht (C) darf im Zuge des Montierens auf die Trommel nicht reißen und nach dem Demontieren und Geradebiegen dürfen sich keine Runzeln, Wellen oder sonstige störende Strukturen bilden. Bei den Bindemitteln der Barriereschicht (C) handelt es sich daher um weichelastische Bindemittel.

Prinzipiell kann für die Barriereschicht (C) jedes weichelastische Bindemittel eingesetzt werden, mit dem die geforderte maximale Sauerstoffdurchlässigkeit erreicht oder unterschritten wird, sofern die anderen Randbedingungen wie Transparenz für UVA-Licht und Löslichkeit in den kommerziell verfügbaren Flexoauswaschmitteln ebenfalls erfüllt sind.

Geeignete, weichelastische Polymere, die in organischen Lösungsmitteln löslich sind und eine ausreichende Sperrwirkung gegen Sauerstoff besitzen, sind beispielsweise teilverseifte Polyvinylacetate mit einem Verseifungsgrad zwischen 30 und maximal 80 Mol-%, Ethylen-Vinylacetat-Copolymere und EthylenVinylalkohol-Copolymere und Ethylen-Vinylacetat-Vinylalkohol-Copolymere. Gut geeignet sind auch cyclische Acetale von Polyvinylakohol wie Polyvinylbutyral, Polyvinylethyral, Polyvinylformal, Polyvinylpropyral sowie Copolymere, die zwei oder mehr verschiedene Vinylacetal-Einheiten, ausgewählt aus Vinylformal-, Vinylethyral-, Vinylpropyral- und Vinylbutyral-Einheiten, enthalten. Diese sind unter den Handelsnamen Butvar^{©} bzw. Mowital^{©} kommerziell erhältlich. Bei den Polyvinylacetalen handelt es sich immer um Copolymere mit Vinylalkoholeinheiten, da die Umsetzung von Polyvinylalkohol zum Vollacetal aus statistischen und sterischen Gründen nicht vollständig ist. So handelt es sich bei Poly(vinylbutyral) genau genommen um ein Poly(vinylbutyral-vinylalkohol). Üblicherweise liegt der Rest-OH-Gehalt der genannten Polyvinylacetale zwischen 10 und 30 Gew.-%. Sehr gut geeignet sind beispielsweise Vinylethyral-vinylbutyral-vinylalkohol-Copolymere (Poly(vinylethyral-vinylbutyral)), die unter dem Handelsnamen Pioloform^{©} kommerziell verfügbar sind.

Bei Verwendung der genannten Polymere zur Formulierung der Barriereschicht (C) ist die Haftung der Barriereschicht (C) zur leicht klebrigen, reliefbildenden Schicht (B) ausreichend hoch. Auf Grund des unpolaren Charakters der Bindemittel der Barriereschicht (C) und den dadurch bedingten geringen Wechselwirkungskräften ist die Anbindung zur laserablatierbaren Maskenschicht (D) aber problematisch. Überraschenderweise wurde gefunden, dass die Anbindung der Barriereschicht (C) an die Maskenschicht (D) selbst dann ungenügend ist, wenn in beiden Schichten identische polymere Bindemittel eingesetzt werden. Eine gute Anbindung der einzelnen Schichten zueinander ist aber für die Handhabbarkeit der Flexodruckplatte bei der Verarbeitung zum Klischee von entscheidender Bedeutung. Insbesondere beim Abziehen der Deckfolie muss die laserablatierbare Maskenschicht (D) vollständig auf der Barriereschicht (C) verbleiben und diese wiederum vollständig auf der reliefbildenden Schicht (B). Kommt es beim Abziehen der Deckfolie zur teilweisen Ablösung einzelner Schichtteile, wird die gesamte Flexodruckplatte dadurch unbrauchbar.

Überraschenderweise wurde gefunden, dass durch den Zusatz einer oligomeren oder polymeren basischen Haftkomponente zur Barriereschicht (C) die Haftung der Barriereschicht zur laserablatierbaren Maskenschicht (D) erheblich verbessert werden kann, und die Flexodruckplatten dann gemäß dem erfindungsgemäßen Verfahren einfach und sicher verarbeitet werden können.

Als Haftkomponente geeignet sind beispielsweise Copolymere oder Cooligomere mit basischen Carboxylat- oder Sulfonatfunktionen, wie beispielsweise neutralisierte oder teilneutralisierte Styrol-Acrylsäure-Copolymere, Styrol-Acrylat-Acrylsäure-Copolymere oder neutralisierte oder teilneutralisierte Ethylen-Acrylsäure-Copolymere, Ethylen-Methacrylsäure-Copolymere und Ethylen-Acrylat-Acrylsäure bzw. -Methacrylsäure-Copolymere. Sehr gut geeignet sind Oligomere und Polymere mit basischen Aminofunktionen wie Polyvinylamin oder Polyethylenimin. Im Gegensatz zu den carboxylatgruppenhaltigen Oligomeren bzw. Polymeren werden die aminogruppenhaltigen Oligomere bzw. Polymere bevorzugt in nicht neutralisierter Form eingesetzt. Für die Haftung scheint die Gegenwart einer basischen Gruppe wesentlich zu sein.

Das zahlenmittlere Molekulargewicht der basischen Haftkomponente sollte mindestens 500 g/mol betragen. Bei kleineren Molekulargewichten kann zwar auch eine Haftungsverbesserung erreicht werden, diese ist aber nicht dauerhaft, vermutlich deshalb, weil die kleinen Moleküle in die anderen Schichten migrieren können. Bevorzugt werden daher Haftkomponenten mit einem zahlenmittleren Molekulargewicht von mindestens 1000 g/mol und ganz besonders bevorzugt mit einem zahlenmittleren Molekulargewicht von mindestens 10 000 g/mol eingesetzt. Die oligomere (1000 g/mol bis 10000 g/mol) oder polymere Haftkomponente (> 10000g/mol) kann linear oder verzweigt oder auch hyperverzweigt sein. Insbesondere bei den Polyethyleniminen können unterschiedliche Verzweigungsgrade vorliegen, was durch den prozentualen Anteil von primären zu sekundären zu tertiären Aminogruppen ausgedrückt werden kann.

Überraschenderweise wird durch den Zusatz einer oligomeren oder polymeren basischen Haftkomponente die Sperrwirkung der Barriereschicht gegenüber Sauerstoff nicht nachteilig beeinflusst. Der Anteil der basischen Haftkomponente in der Barriereschicht, bezogen auf alle Komponenten der Barriereschicht (C), beträgt von 1 bis 30 Gew.-%, bevorzugt von 3 bis 15 Gew.-%.

In einer besonderen Ausführungsform der Erfindung enthält die Barriereschicht (C) zusätzlich noch einen Füllstoff. Dieser verändert die Oberfläche der Barriereschicht und verleiht ihr eine typische Topographie, welche bei der Belichtung mit UVA-Licht 1:1 auf die Oberfläche der reliefbildenden Schicht (B) übertragen werden kann. Da die Nachdiffusion von Sauerstoff während der flächigen Belichtung mit UVA-Licht durch die Präsenz der Barriereschicht nahezu komplett ausgeschaltet ist, gelingt es auf diese Weise, maßgeschneiderte Oberflächenrauhigkeiten mit hoher Präzision auf der reliefbildenden Schicht abzubilden.

Als Füllstoffe kommen anorganische Füllstoffe, wie Silicate, Quarzmehle, Glaspartikel, Siliciumoxide oder Aluminium- oder Titanoxide aber auch natürliche Mineralien wie beispielsweise Hydroxyapatit, Talkum, Calciumsulfat oder Calciumcarbonat oder Pigmente wie beispielsweise Eisen- oder Chromoxide in Frage. Die Füllstoffe können oberflächenbehandelt oder oberflächenfunktionalisiert sein, um eine gleichmäßige Dispergierung der Füllstoffteilchen in der Barriereschicht (C) zu gewährleisten.

In einer speziellen Ausführungsform können auch organische Materialien wie Polyethylen, Polycarbonate und Poly(meth)acrylate verwendet werden. Die Füllstoffpartikel können vernetzt oder unvernetzt vorliegen und können auch mit organischen funktionellen Gruppen funktionalisiert sein.

Die Form der Füllstoffe ist beliebig. Es können runde Partikel oder kristalline Partikel mit beliebiger Form verwendet werden. Die Form der Partikel hat aber einen entscheidenden Einfluss auf die Topographie der jeweiligen Oberfläche. So können maßgeschneiderte Oberflächen für unterschiedliche Farbsysteme und verschiedene Druckanwendungen, beispielsweise für den Druck flexibler Verpackungen, den Etikettendruck oder den Druck auf Papier, Karton oder Wellpappe formuliert werden.

Je nach Oberflächenfunktionalität der jeweiligen Füllstoffteilchen kann der Prozess der Abformung der Topographie der Barriereschicht (C) auf die reliefbildende Schicht (B) unterschiedlich verlaufen. Ist ein Füllstoff beispielsweise mit ethylenisch ungesättigten Gruppen an der Oberfläche funktionalisiert, so werden die Füllstoffteilchen bei der flächigen UVA-Belichtung mit den Monomeren der reliefbildenden Schicht reagieren. Als Folge davon wird der Füllstoff in die reliefbildende Schicht übertragen. Analytisch ist dieser Prozess an Hand mikroskopischer Aufnahmen zu belegen. Die Füllstoffteilchen stehen dann aus der Oberfläche der Flexoklischees heraus. Die Topographie wird übertragen.

Unfunktionalisierte Füllstoffe werden dagegen nicht in die reliefbildende Schicht eingebaut, sondern drücken sich nur mechanisch in die weiche reliefbildende Schicht ab. Die Füllstoffpartikel werden beim Auswaschen des Reliefs mit entfernt. Als Folge davon werden auf dem Druckklischee später entsprechende Vertiefungen oder Löcher beobachtet. Die Topographie der Barriereschicht (C) wird nur abgeformt.

Welcher Prozess für ein optimales Druckergebnis zu bevorzugen ist, kann nicht allgemein vorhergesagt werden. Unterschiedliche Topographien können sich bei unterschiedlichen Druckfarbensystemen und Druckanwendungen völlig unterschiedlich auswirken. Grundsätzlich sollte eine erfindungsgemäße Flexodruckplatte aber entweder die Topographie abformen oder übertragen. Eine teilweise Übertragung und ein teilweises Abformen ist für eine konsistente Oberflächenqualität nicht hilfreich.

Es sei darauf hingewiesen, dass die Übertragung oder Abformung der Oberflächentopographie der Barriereschicht (C) auf die reliefbildende Schicht (B) nur dann 1:1 erfolgt, wenn die Barriereschicht die geforderte, niedrige Sauerstoffdurchlässigkeit aufweist. Werden andere Polymere mit höherer Sauerstoffdurchlässigkeit als Bindemittel für die Barriereschicht verwendet, dann verhindert der bei der UVA-Belichtung nachdiffundierende Sauerstoff die Vernetzung der Oberfläche der reliefbildenden Schicht. Die oberste Schicht wird dann beim Auswaschen mit entfernt, so dass die Topographie nicht 1:1 übertragen bzw. abgeformt wird.

Die Übertragung bzw. Abformung der Topographie muss gleichmäßig auf alle Reliefelemente, Vollflächen und feine Rasterpunkte, erfolgen. Dies gelingt insbesondere dann, wenn als Bindemittel die erfindungsgemäßen Bindemittel mit niedriger Sauerstoffdurchlässigkeit eingesetzt werden. Besonders gut gelingt die Übertragung bzw. Abformung der Topographie wenn als Bindemittel die erfindungsgemäßen Polyvinylacetale und als Füllstoffe anorganische Silikate bzw. Siliciumdioxid verwendet werden.

Die mittlere Teilchengröße der Füllstoffe liegt in einem Bereich von 2 bis 15 µm, bevorzugt von 3 bis 8 µm. Der Anteil der anorganischen Füllstoffe in der Barriereschicht liegt in einem Bereich von 5 bis 30 Gew.-%. Bei höheren Anteilen wird die Transparenz der Barriereschicht zu stark reduziert. Bei kleineren Anteilen wird keine mikroskopisch gleichmäßige Rauhigkeit erzielt. Verwendet man organische Füllstoffe, so kann der Brechungsindex zwischen Füllstoff und Matrixpolymer abgestimmt werden, so dass in diesem Fall auch höhere Füllstoffanteile (bis zu 50 Gew.-%) realisiert werden können.

Durch den Zusatz eines Füllstoffes in die Barriereschicht (C) wird diese im Normalfall steifer und klebfrei, was zu einer verminderten Haftung führt, wodurch die oben beschriebenen Haftungsprobleme zwischen Barriereschicht (C) und Maskenschicht (D) größer werden. Daher ist es bei dieser Ausführungsform von besonderer Bedeutung, eine oligomere oder polymere basische Haftkomponente in der Barriereschicht (C) einzusetzen.

Im Allgemeinen enthält die Sauerstoff-sperrende Barriereschicht (C)
50 bis 99 Gew.-%, bevorzugt 65 bis 95 Gew.-% des Sauerstoff-sperrenden Bindemittels,
1 bis 30 Gew.-%, bevorzugt 3 bis 15 Gew.-% der basischen Haftkomponente, und 0 bis 50 Gew.-%, bevorzugt 1 bis 30 Gew.-% Füllstoffe.

Die Schichtdicke der Barriereschicht (C) beträgt in der Regel 0,3 µm bis 5 µm. Bei Schichtdicken unterhalb von 0,3 µm ist es schwierig, einen homogenen, gleichmäßigen Auftrag und eine ausreichend gleichmäßige Sperrwirkung gegenüber Sauerstoff zu erreichen. Bei Schichtdicken oberhalb von 5 µm kann die Abbildungsgenauigkeit durch zunehmende Streueffekte des UVA-Lichtes reduziert werden und die Dehnbarkeit der Schicht wird beeinträchtigt. Bevorzugt beträgt die Schichtdicke daher 0,5 µm bis 3 µm, besonders bevorzugt 1 µm bis 2 µm. Die Schichtdicken können gemessen werden, beispielsweise mittels mikroskopischer Aufnahmen eines Schnittes, oder sie können alternativ aus dem Auftragsgewicht und der Dichte des aufgetragenen Materials berechnet werden.

### Laserablatierbare Maskenschicht (D)

Auf die Barriereschicht (C) ist eine in organischen Lösemitteln lösliche oder dispergierbare laserablatierbare Maskenschicht (D) aufgebracht. In die laserablatierbare Maskenschicht (D) wird die zu druckende Information mittels eines geeigneten Lasers eingeschrieben.

Die Maskenschicht (D) umfasst mindestens ein elastomeres, in organischen Lösungsmitteln lösliches Bindemittel und UV-VIS-Licht absorbierende Komponenten.

Für die Löslichkeit der Maskenschicht gilt das gleiche wie für die Löslichkeit der Barriereschicht. Das Vorhandensein der Maskenschicht verlängert das Auswaschen der Flexodruckplatten in marktüblichen Auswaschmitteln nicht wesentlich.

Auch die mechanischen Anforderungen an die Bindemittel der Maskenschicht entsprechen den mechanischen Anforderungen an die Bindemittel der Barriereschicht. Die Maskenschicht darf beim Biegen/Dehnen nicht reißen und beim Geradebiegen keine Runzeln oder Wellen bilden. Daher sind die Bindemittel im Allgemeinen weichelastisch.

Das Bindemittel der Barriereschicht kann mit dem Bindemittel der Maskenschicht identisch sein, es kann aber auch verschieden sein.

Gut geeignete, weichelastische Bindemittel für die Maskenschicht sind beispielsweise Ethylenvinylacetate, weichelastische Polyamide, weichelastische Polyurethane, Nitrocellulose, Polyvinylacetale wie beispielsweise Poly(vinybutyral-vinylalkohol)-Copolymere (Butvar^{®}, Mowital^{®}) oder Poly(vinylbutyral-vinylethyral-vinylalkohol)-Copolymere (Pioloform^{®}). Selbstverständlich können auch andere weichelastische Materialien als Bindemittel eingesetzt werden, wie beispielsweise teilverseifte Polyvinylacetate. Bevorzugtes Bindemittel für die Maskenschicht ist das weichelastische Polyamid Makromelt^{®} 6900.

Die laserablatierbare Maskenschicht (D) enthält neben dem Bindemittel UV/VIS-Licht absorbierende Materialien, wobei die Schichtdicke und/oder die Menge der lichtabsorbierenden Materialien im Allgemeinen so bemessen werden, dass die optische Dichte der Schicht für UVA-Strahlung 1 bis 5 beträgt. Der UVA-Strahlungsbereich umfasst Licht der Wellenlänge von 300 bis 400 nm. Die optische Dichte ist die logarithmische Maßzahl für die Lichtundurchlässigkeit der Schicht in diesem Wellenlängenbereich. Bei der Messung der optischen Dichte wird daher kein Einzelwert der Lichtundurchlässigkeit bei einer bestimmten Wellenlänge ermittelt, sondern ein Mittelwert der Lichtundurchlässigkeiten in einem definierten Wellenlängenbereich. Üblicherweise erfolgt die Messung der optischen Dichte mittels kommerziell verfügbarer Densitometer (z.B. von x-rite), wobei der Wellenlängenbereich vor der Messung ausgewählt wird. Im Sinne der Erfindung beziehen sich alle zitierten Messwerte der optischen Dichte auf den UVA-Bereich, d.h. den Bereich von 300 bis 400 nm.

Bevorzugte optische Dichten der Maskenschicht (D) liegen im Bereich von 2 bis 5. Die hohe optische Dichte gewährleistet, dass die von der Maske bedeckten Bereiche der reliefbildenden Schicht (B) im Zuge der vollflächigen Belichtung mit UVA-Licht nicht polymerisieren.

Als lichtabsorbierendes Material eignen sich insbesondere feinteiliger Ruß, Graphit oder Ruß-Nanopartikel oder Kohlenstoff-Nanoröhrchen. Diese absorbieren sehr gut im nahen IR Bereich und gewährleisten so bei der Bebilderung mittels IR-Lasern, wie beispielweise IR Laserdioden (830 nm) oder Nd-YAG-Lasern (1064 nm) eine schnelle Bilderzeugung. Selbstverständlich kann die laserablatierbare Maskenschicht (D) aber auch andere UV- oder IR-Absorber auf Pigmentbasis oder lösliche Farbstoffe enthalten. Als Farbstoffe können beispielsweise Phthalocyanine und substituierte Phthalocyanin-Derivate, Cyanin-, und Merocyaninfarbstoffe oder auch Polymethinfarbstoffe oder Azofarbstoffe verwendet werden.

Der Nachteil der molekularen, löslichen Farbstoffe ist, dass sie aus der laserablatierbaren Maskenschicht in andere Schichten des Flexodruckelements diffundieren können, wodurch die optische Dichte der Maskenschicht verringert und die der anderen Schichten erhöht wird, was zur Folge hat, dass sich die Verarbeitungszeiten der Flexodruckplatte über der Lagerzeit verändern. Ferner wird die Qualität der hergestellten Klischees vermindert. Aus diesem Grunde werden UV- und IR-Absorber auf Pigmentbasis wie Ruß, Graphit und Kohlenstoff-Nanopartikel oder Kohlenstoff-Nanoröhrchen bevorzugt.

Die Menge der lichtabsorbierenden Materialien beträgt in der Regel 10 Gew.-% bis 60 Gew.-% bezüglich der Menge aller Komponenten der laserablatierbaren Maskenschicht.

Die laserablatierbare Maskenschicht (D) kann optional darüber hinaus noch Weichmacher, Stabilisatoren oder weitere Hilfsmittel beispielsweise Emulgatoren, Verlaufshilfsmittel oder UV-Absorber enthalten. Diese Materialien müssen allerdings eine so hohe Molmasse haben, dass eine Diffusion in andere Schichten des Flexodruckelements aufgrund der Molekülgröße unterbunden ist oder die diffundierten Materialien in den anderen Schichten ohne Einfluss und Funktion sind und somit auch die Herstellung des Flexodruckklischees nicht stören.

Die Schichtdicke der laserablatierbaren Maskenschicht (D) beträgt in der Regel bevorzugt 0,3 µm bis 5 µm. Bei Schichtdicken unterhalb von 0,3 µm ist es schwierig, eine ausreichende optische Dichte zu erreichen. Bei Schichtdicken von mehr als 5 µm ist die Laserempfindlichkeit des Elementes zu gering, so dass lange Laserzeiten zur Bebilderung notwendig sind. Die Laserempfindlichkeit der Maskenschicht (gemessen als die Energie, die notwendig ist, um 1 cm² Schicht zu ablatieren) sollte zwischen 0,5 und 4 mJ/cm² liegen. Bevorzugt beträgt die Schichtdicke 1 µm bis 3 µm.

### Deckfolie (E)

Die Flexodruckplatten enthalten als oberste Schicht eine abziehbare Deckfolie (E), welche unter anderem dem Schutz der Flexodruckplatte dient. Die Deckfolie wird vor der Bebilderung der Flexodruckplatte mittels des IR-Lasers abgezogen. Als abziehbare Deckfolien (E) eignen sich insbesondere PET-Folien mit mäßiger oder geringer Rauhigkeit. Typische gemittelte Einzelrautiefen (Rz) sollten zwischen 0,2 und 2,0 µm liegen. Die Mittelrauwerte (Ra) sollten zwischen 0,02 und 0,5 µm liegen.

Die Rauhigkeit der Deckfolie ist für das Abziehen der Deckfolie von dem Verbund aus Trägerfolie, reliefbildender Schicht, Barriereschicht und Maskenschicht wichtig. Je rauer die Deckfolie desto größer ist die Kontaktfläche zwischen Deckfolie und Maskenschicht und umso größere Kräfte müssen beim Abziehen der Deckfolie aufgewendet werden. Eine glatte Folie ist für eine sichere Handhabung deshalb vorzuziehen.

Eine glatte Deckfolie hat noch den weiteren Vorteil, dass die Auftragsmenge der laserablatierbaren Maskenschicht reduziert werden kann, wodurch sich die Laserempfindlichkeit erhöht. Bei einer rauen Deckfolie ist dies nicht möglich, da alle Täler der Deckfolie vollständig ausgefüllt und alle Spitzen bedeckt sein müssen, damit über der gesamten Fläche eine hohe optische Dichte erzielt wird und keine Löcher auftreten. Beispielsweise kann eine Mylar^{®} A PET-Folie eingesetzt werden.

### Herstellung der Flexodruckplatten

Die Herstellung der Flexodruckplatten erfolgt in prinzipiell bekannter Art und Weise, indem man die Komponenten der fotopolymerisierbaren Schicht in einem Extruder aufschmilzt, mischt und die Schmelze des fotopolymerisierbaren Materials durch eine Breitschlitzdüse in den Spalt eines Kalanders austrägt. Über die eine Kalanderwalze läuft eine - optional mit weiteren Schichten, wie beispielsweise einer Haftschicht beschichtete - Trägerfolie und über die andere Kalanderwalze läuft ein vorgefertigtes Deckelement ein. Der Schichtenverbund aus dimensionstabiler Trägerfolie (A), fotopolymerisierbarer Schicht (B) sowie Deckfolie (E) mit den Schichten (D) und (C) wird durch Kalandrieren miteinander verbunden.

Bei dem Deckelement handelt es sich um die Deckfolie (E), welche mit der laserablatierbaren Maskenschicht (D) und der Barriereschicht (C) vorbeschichtet ist.

Bei der Herstellung des Deckelementes wird zunächst die laserablatierbare Maskenschicht (D) auf die Deckfolie (E) aufgetragen. Dies kann aus Lösung, aus der Schmelze oder durch Sprühen erfolgen. Anschließend wird die laserablatierbare Maskenschicht (D) mit der Barriereschicht (C) überschichtet.

Um das Anlösen der ersten, bereits aufgebrachten Maskenschicht (D) beim Überschichten mit der Barriereschicht (C) zu vermeiden, kann es erforderlich sein, die Lösungsmittelzusammensetzung der Gießlösungen zu variieren. Vor Auftragung der jeweils nächsten Schicht kann es erforderlich sein, die zu beschichtende Oberfläche mittels Elektronenstrahl anzuvernetzen, um eine bessere Überschichtbarkeit zu erreichen. Auch eine Coronavorbehandlung der zuerst aufgebrachten Maskenschicht kann hilfreich sein, um eine bessere Anbindung der Schichten untereinander zu erreichen. Einschränkend muss gesagt werden, dass die Effekte durch eine Coronavorbehandlung oftmals mit der Lagerzeit der Druckplatte nachlassen und keine dauerhaft gute Haftung erreicht wird.

Alternativ können die einzelnen Schichten auch separat auf verschiedene Folien beschichtet werden und anschließend zusammenlaminiert werden. Beispielsweise können die Maskenschicht (D) und die Barriereschicht (C) auch separat auf jeweils eine Folie beschichtet werden. Die Maskenschicht (D) wird hierbei auf die spätere Deckfolie (E) aufgetragen, während die Barriereschicht (C) auf eine temporäre Hilfsfolie aufgetragen wird. Nach dem Beschichten werden beide Folien mit den Schichtseiten aufeinander laminiert und die temporäre Hilfsfolie abgezogen.

Gießtechniken zum Aufbringen von Schichten sind dem Fachmann bekannt. Die Schichtdicke der aufzubringenden Schichten kann in prinzipiell bekannter Art und

Weise durch Verdünnung der Gießlösung bzw. Veränderung der Beschichtungsparameter wie Rakelspalt oder Beschichtungsgeschwindigkeit verringert werden. Zur Verbesserung der Beschichtungsqualität kann es erforderlich sein, der Beschichtungslösung oberflächenaktive Substanzen oder Verlaufshilfsmittel zuzusetzen.

Das beschichtete Deckelement wird aufgerollt und bei der nachfolgenden Extrusion über eine der Kalanderwalzen eingefahren und so haftfest mit der fotopolymerisierbaren, reliefbildenden Schicht (B) verbunden.

Alternativ können Teile des Deckelementes auch in mehreren Schritten auflaminiert werden. Beispielsweise kann ein Deckelement aus einer Barriereschicht (C) auf einer temporären Hilfsfolie über die Kalanderwalzen eingefahren und mit der fotopolymerisierbaren Schicht (B) verbunden werden. Die Hilfsfolie wird anschließend abgezogen. In einem zweiten Laminierschritt wird dann die laserablatierbare Maskenschicht (D) mit der eigentlichen Deckfolie aufkaschiert. Die Haftung zwischen Barriere- und laserablatierbarer Maskenschicht baut sich dann in den folgenden Tagen auf. Grundsätzlich gilt, dass die Haftung der Druckplatten erst nach einer Lagerzeit von 2 Wochen konstant ist und Haftungsmessungen erst nach dieser Zeit durchgeführt werden sollten.

### Verarbeitung der Flexodruckelemente zu Flexodruckformen

Die Herstellung von Flexodruckformen aus den Flexodruckelementen umfasst die Verfahrensschritte (i) bis (v):
(i) Abziehen der Deckfolie (E),
(ii) Einschreiben einer Maske in die laserablatierbare Maskenschicht (D) mithilfe eines IR-Lasers,
(iii) Belichten des bebilderten Flexodruckelements mit UVA-Licht durch die gebildete Maske hindurch,
(iv) Entfernen der Reste der laserablatierbaren Maskenschicht (D), der Barriereschicht (C) sowie der nicht polymerisierten Anteile der reliefbildenden Schicht (B) durch Erwärmen und Entfernen der nicht belichteten Bereiche mittels eines Entwicklungsmaterials,
(v) optional Nachbelichtung der getrockneten Flexodruckplatte mit UVA- und/oder UVC-Licht.

Gegenstand der Erfindung sind auch die so hergestellten Flexodruckformen selbst.

In Verfahrensschritt (i) wird die Deckfolie (E) vom Flexodruckelement entfernt. Dabei müssen die laserablatierbare Maskenschicht (D) und die Barriereschicht (C) komplett auf der reliefbildenden Schicht (B) verbleiben. Dies ist mit den erfindungsgemäßen Flexodruckelementen problemlos möglich.

In Verfahrensschritt (ii) wird eine Maske in die laserablatierbare Maskenschicht (D) mithilfe eines IR-Lasers eingeschrieben. Laserapparaturen zum Einschreiben von Masken sind dem Fachmann bekannt und sind kommerziell erhältlich. Prinzipiell können alle marktüblichen Laser (überwiegend Außentrommellaser) verwendet werden. Die Flexodruckelemente werden bei der Montage auf der Lasertrommel gedehnt. Die Barriereschicht (C) und die laserablatierbare Schicht (D) dürfen dabei nicht reißen, was mit den erfindungsgemäßen Flexodruckelementen problemlos möglich ist.

In Verfahrensschritt (iii) wird das bebilderte Flexodruckelement mit flächiger UVA-Strahlung durch die gebildete Maske und durch die Barriereschicht (C) hindurch belichtet. Hierbei polymerisiert die fotopolymerisierbare Schicht in den von der Maske nicht mehr abgedeckten Bereichen, während in den abgedeckten Bereichen keine Polymerisation erfolgt. Die fotopolymerisierbare Schicht wird während der Belichtung durch die Barriereschicht (C) vor dem Einfluss von nachdiffundierendem Sauerstoff geschützt. Die Belichtung kann daher mit marktüblichen UVA-Röhrenbelichtern oder UV-LED-Leisten erfolgen. Eine aufwändige Belichtung unter Luftausschluss oder das aufwändige Auflaminieren eines Films oder das Auflaminieren einer gegen Sauerstoff sperrenden Folie sind bei Verwendung der erfindungsgemäßen Flexodruckelemente nicht notwendig.

In Verfahrensschritt (iv) werden die Reste der laserablatierbaren Maskenschicht (D), und die Barriereschicht (C) sowie die nicht polymerisierten Anteile der reliefbildenden Schicht (B) durch Erwärmen und Entfernen der nicht belichteten Bereiche mittels eines Entwicklungsmaterials entfernt.

In nicht-erfindungsgemäßen alternativen Ausführungsformen kann das Entfernen durch Verwenden von kommerziell verfügbaren Flexoauswaschmitteln erfolgen. Dies kann unter Verwendung üblicher Auswaschgeräte, insbesondere unter Verwendung von Flachbett-Auswaschgeräten erfolgen. Bevorzugt wird ein Auswaschmittel verwendet, welches mindestens ein organisches Lösungsmittel enthält.

Kommerziell verfügbare Flexoauswaschmittel sind beispielsweise in der EP 332 070 beschrieben. Im Allgemeinen enthalten diese aliphatische, cycloaliphatische oder aromatische Kohlenwasserstoffe und einen oder mehrere Alkohole. Die meisten im Markt verwendeten Auswaschmittel enthalten unpolare Kohlenwasserstoffe als Hauptkomponente sowie Alkohole mittlerer Polarität in einer Menge von 10 bis 30 Gew.-%. Beispiele kommerzieller Auswaschmittel umfassen Mischungen enthaltend ca. 40 Gew.-% hochsiedende Kohlenwasserstofflösemittel, ca. 40 Gew.-% Decalin und ca. 20 Gew.-% n-Pentanol, Mischungen enthaltend ca. 50% hochsiedende Kohlenwasserstofflösemittel, ca. 20 Gew.-% Diisopropylbenzol und ca. 30 Gew.-% Cyclohexanol, Mischungen enthaltend ca. 56 Gew.-% Decalin, ca. 27 Gew.-% aliphatisches Kohlenwasserstofflösemittel, ca. 12 Gew.-% Benzylalkohol und ca. 2 Gew.-% Ethylhexanol sowie Mischungen enthaltend ca. 70 Gew.-% aromatische Kohlenwasserstoffe und ca. 30 Gew.-% Heptylalkohole.

Erfindungsgemäß werden die Flexodruckelemente thermisch entwickelt. Hierbei werden die Flexodruckelemente auf eine Trommel montiert und von der Oberfläche her bis zum Aufschmelzen erwärmt. Anschließend wird eine Gewebeband auf die Flexodruckelemente aufgepresst und die nicht belichteten Bereiche der reliefbildenden Schicht, die Barriereschicht und die Reste der laserablatierbaren Maskenschicht abgezogen. Dieser Vorgang wird mehrmals wiederholt, bis die gewünschte Relieftiefe erreicht ist.

Sollte ein Auswaschmittel in Verfahrensschritt (iv) verwendet worden sein, wird die erhaltene Flexodruckplatte gegebenenfalls in prinzipiell bekannter Art und Weise getrocknet.

Optional schließt sich ein weiterer Verfahrensschritt (v) an, bei dem in prinzipiell bekannter Art und Weise mit UVA und/oder UVC-Licht nachbelichtet wird.

Das Verfahren kann selbstverständlich optional noch weitere Verfahrensschritte umfassen. Beispielsweise kann vor oder nach dem Einschreiben der Maske mittels IR-Laser eine Vorbelichtung durchgeführt werden. Hierbei werden die erfindungsgemäßen Flexodruckelemente durch die Trägerfolie hindurch belichtet, wodurch ein gleichmäßiger Reliefgrund erzeugt wird und die Höhe des gewünschten Reliefs eingestellt werden kann.

### Beispiele

### Herstellung der Flexodruckplatten

Die folgenden Komponenten wurden in den Beispielen eingesetzt:
Makromelt^{®} 6900, ein weichelastisches Polyamid der Firma Henkel.
Spezial Schwarz 4, ein amorpher Ruß der Firma Evonik.
Mowital^{®} B16H, ein Polyvinylbutyral mit einem Rest-OH-Gehalt von 19.5%, der Firma Kuraray.
Pioloform^{®} BL16, ein Poly(vinylbutyral-vinylethyral)-Copolymer mit einem Rest-OH-Gehalt von 16% der Firma Kuraray.
Loxanol^{®} MI 6735, ein Polyethylenimin mit einem Molekulargewicht von 25.000 g/mol von BASF.
Lupasol^{®} P, ein Polyethylenimin mit einem Molekulargewicht von 750.000 g/mol von BASF.
Syloid^{®} ED 3, ein amorphes Siliciumdioxid mit einer mittleren Teilchengröße von 5.8 µm von Grace.

Die Erfindung wird in den folgenden Beispielen näher beschrieben. Die Versuche wurden im technischen Maßstab durchgeführt, was bedeutet, dass großformatige Flexodruckplatten im Format 1270 mm x 2032 mm hergestellt wurden. Als Ausgangsmaterial wurde eine nyloflex^{®} NEF 114 D Flexodruckplatte von Flint Group eingesetzt. Alle %-Angaben sind als anteilige Gewichtsprozente zu verstehen.

Die Komponenten der reliefbildenden Schicht der nyloflex^{®} NEF-Flexodruckplatte wurden in einem Doppelschneckenextruder vom Typ ZSK gemischt und aufgeschmolzen. Die Schmelze wurde bei einer Temperatur von 130 °C durch eine Breitschlitzdüse ausgetragen und in einen Kalander eingefahren. Über die obere Kalanderwalze wurde eine zuvor mit der laserablatierbaren Maskenschicht und der Barriereschicht beschichtete PET-Deckfolie eingefahren. Über die untere Kalanderwalze wurde eine PET-Trägerfolie eingefahren. Der Verbund wurde über ein Vakuumsaugband abgezogen, abgekühlt und zu dem gewünschten Plattenformat von 1270 mm x 2032 mm zugeschnitten. Die Flexodruckplatte hatte eine Gesamtstärke von 1,27 mm. Nach einer Lagerzeit von 2 Wochen wurden die Flexodruckplatten vermessen und zu Flexodruckklischees weiterverarbeitet.

In allen Versuchen wurde als Deckfolie eine 0,1 mm starke PET-Folie vom Typ Mylar^{®} A eingesetzt. Auf diese Deckfolie wurde jeweils eine laserablatierbare Maskenschicht aufgebracht. Die Maskenschicht enthielt 65% Makromelt^{®} 6900 und 35% Spezial Schwarz 4. Zur Herstellung der Schicht wurde das Makromelt^{®} 6900 in einer Lösung bestehend aus gleichen Teilen Toluol und n-Propanol gelöst. Anschließend wurde das Spezial Schwarz 4 portionsweise zugefügt und die Lösung 5h über eine Kugelmühle gefahren. Der Feststoffgehalt der Dispersion betrug 12%. Die Dispersion wurde anschließend über eine Rakelwalze auf die Mylar^{®} A Folie beschichtet und bei 75°C getrocknet. Das Trockenauftragsgewicht der Schicht betrug 2,9 g/m² und die optische Dichte lag über der gesamten Beschichtungsbreite in einem Bereich von 3,7 bis 4,0.

Die mit der Maskenschicht beschichtete Deckfolie wurde anschließend mit der Barriereschicht überschichtet. Die Zusammensetzung der jeweiligen Barriereschichten ist in der folgenden Tabelle enthalten.

| Versuchsnummer | Komponenten Barriereschicht | Anteile in Gew.% |
|---|---|---|
| VV1 (Vergleich) | --- | --- |
| VV2 (Vergleich) | Mowital B16H | --- |
| V1 | Mowital B16H | 93 |
| | Loxanol MI6735 | 7 |
| V2 | Mowital B 16H | 91 |
| | Lupasol P | 9 |
| V3 | Pioloform BL16 | 95 |
| | Lupasol P | 5 |
| V4 | Pioloform BL16 | 77 |
| | Loxanol MI 6735 | 7 |
| | Syloid ED 3 | 16 |
| V5 | Pioloform BL16 | 71 |
| | Loxanol MI6735 | 9 |
| | Syloid ED3 | 20 |

Zur Herstellung der Barriereschicht (C) wurde das Bindemittel in einem Lösungsmittelgemisch bestehend aus 20% Wasser und 80% iso-Propanol bei Zimmertemperatur gelöst. Anschließend wurden die Haftkomponente und gegebenenfalls der Füllstoff zugefügt und die Lösung bzw. die Dispersion 30 Minuten gerührt. Der Feststoffgehalt der Beschichtungslösung betrug 12%. Die Beschichtungslösung wurde anschließend über eine Rakelwalze auf die Maskenschicht aufgetragen und bei 65 °C getrocknet. Das Trockenauftragsgewicht der Schicht betrug 2,8 g/m². Die so zweimal beschichteten Deckfolien wurden anschließend wie oben beschrieben in den Kalander eingefahren und so haftfest mit der reliefbildenden Schicht der Flexodruckplatte verbunden.

### Verarbeitung der Flexodruckplatten zu Flexodruckklischees und Druck

Nach einer Lagerzeit von 2 Wochen wurden die Flexodruckplatten zum Klischee verarbeitet und ausgewertet. Die Flexodruckplatten wurden zunächst rund 30 Sekunden rückseitig vorbelichtet (nyloflex^{®} F V Belichter, Flint Group).

Anschließend wurde die Deckfolie abgezogen. Das Abziehen der Deckfolie wurde statistisch ausgewertet. Hierzu wurden von jeweils 10 großformatigen Platten die Deckfolie manuell abgezogen und die Druckplatten auf Ablösungen an den Kanten und Ecken hin untersucht. Die Anzahl der fehlerfreien Platten wurde notiert.

Ferner wurde die Haftung der Deckfolie und die Haftung der laserablatierbaren Maskenschicht zur darunterliegenden Barriereschicht bestimmt. Die Haftungsmessungen wurden an 4cm breiten Streifen auf einer Zwick Zug-Dehnungs-Prüfmaschine bestimmt.

Die Flexodruckplatten wurden dann auf die Trommel eines IR-Lasers (CDI^{®} Spark 4835 von der Firma Esko) montiert und mit einer Auflösung von 2540 dpi mit einem geeigneten Motiv bebildert. Das Testmotiv enthielt unter anderem einen Rasterkeil mit gestaffelten Tonwerten (1% bis 5% Rasterfelder im Abstand von 0.2%) bei einer Auflösung von 146 Ipi.

Die so vorbereitete Platte wurde anschließend für 14 Minuten mit UVA-Strahlung belichtet (nyloflex^{®} F V Belichter, Flint Group) und anschließend entwickelt.

Die lösemittelbasierte Entwicklung der bildmäßig belichteten Flexodruckplatten wurde bei der jeweils angegebenen Auswaschgeschwindigkeit und mit der für den jeweiligen Produkttyp empfohlenen Bürstenstellung mit Hilfe eines nyloflex^{®} F V-Auswaschgeräts von Flint Group durchgeführt. Als Auswaschmittel wurde nylosolv^{®} A von Flint Group eingesetzt, ein handelsübliches Flexoauswaschmittel aus ca. 70% Kohlenwasserstofflösemittel und ca. 30% Alkohol. Nach dem Auswaschprozess wurden die noch lösemittelhaltigen Klischees laut den produktspezifischen Empfehlungen 120 Minuten bei 60 - 65°C getrocknet und anschließend in der Nachbelichtungseinheit eines nyloflex^{®} F V-Belichters mit UVA- und UVC-Licht nachbelichtet. Die Flexoklischees wurden mikroskopisch ausgewertet und der kleinste Rastertonwert, der einwandfrei auf dem Flexoklischee abgebildet werden konnte, ermittelt. Ferner wurde die Relieftiefe ermittelt.

Anschließend wurden die Flexoklischees mit den folgenden Druckparametern angedruckt.
Druckmaschine: W&H Zentralzylindermaschine
Substrat: PE-Folie weiß
Druckfarbe: Alkohol basierte Flexodruckfarbe Flexistar Cyan
Klebeband: Lohmann 5.3
Druckgeschwindigkeit: 100m/min
Druckbeistellung: optimal (+ 70µm über Kissprint Einstellung)

An Hand der Druckmuster wurde die optische Dichte einer gedruckten Vollfläche ermittelt.

Die Ergebnisse der Haftungsmessungen, sowie die Ergebnisse der Klischee- und Druckauswertung sind in der folgenden Tabelle zusammengefasst.

| Versuch | Deckfolien-Haftung (cN/4cm) | Maskenschichthaftung (cN/4cm) | Statistischer Abziehtest*) | Relieftiefe (µm) | Kleinster stabiler Tonwert bei 146Ipi(%) | Volltondichte (OD) |
|---|---|---|---|---|---|---|
| VV1 | 13,9 | 87,1 | 10 | 820 | 3,8 | 1,50 |
| VV2 | 14,5 | 22,1 | 1 | 820 | 1.6 | 1,53 |
| V1 | 15,8 | 88,7 | 10 | 790 | 1.4 | 1,50 |
| V2 | 16,4 | 104 | 10 | 810 | 1,4 | 1,54 |
| V3 | 17,4 | 44,0 | 9 | 800 | 1,6 | 1,55 |
| V4 | 15,7 | 67,1 | 10 | 820 | 1,6 | 1,74 |
| V5 | 25,6 | 148,5 | 10 | 800 | 1,4 | 1,69 |

| | | | | | | |
|---|---|---|---|---|---|---|
| *) Anzahl fehlerfreier Platten beim Abziehen der Deckfolie von jeweils 10 Platten | | | | | | |

Die Ergebnisse belegen eindrucksvoll die Erhöhung der Haftwerte durch den Zusatz der basischen Haftkomponente. Nur bei V3 mit einem relativ niedrigen Anteil der Haftkomponente von 5% ist die Haftungserhöhung nicht besonders ausgeprägt.

Die Haftwerte korrelieren mit den Ergebnissen des statistischen Deckfolienabziehtests. Vergleichsversuch VV1 ohne Barriereschicht zeigt eine gute Haftung. Das Abziehen der Deckfolie funktioniert problemlos. Vergleichsversuch VV2 mit Barriereschicht aber ohne Haftkomponente zeigt eine schwache Haftung der Maskenschicht zur darunter liegenden Barriereschicht und dementsprechend ein sehr schlechtes Abziehergebnis. Nur von einer Platte von zehn konnte die Deckfolie fehlerfrei entfernt werden. Alle anderen Versuchseinstellungen mit Barriereschicht mit Haftkomponente zeigten dagegen im Abziehtest sehr gute Ergebnisse.

Die Relieftiefen aller Versuchseinstellungen sind unauffällig. Dies ist ein Beleg dafür, dass die zusätzliche Barriereschicht das Auswaschen nicht beeinträchtigt. Die Sperrwirkung gegenüber Sauerstoff ist bei den Flexodruckplatten mit Barriereschicht ausgeprägt. Rastertonwerte von 1,4% oder 1,6% können einwandfrei auf der Platte abgebildet werden. Die Flexoplatte ohne Barriereschicht (VV1) kann dagegen nur einen kleinsten Tonwert von 3,8% auf dem Klischee halten. Bemerkenswert ist die hohe Farbdichte, die in den Versuchen V4 und V5 erreicht wird. Diese Versuche enthalten in der Barriereschicht einen anorganischen Füllstoff, der die Barriereschicht rau macht. Diese Rauhigkeit wird auf die Oberfläche des Flexoklischees abgeformt, wodurch sich ein erheblich verbesserter Farbübertrag im Druck erzielen lässt.

### Kurze Beschreibung der Figuren

Figur 1 zeigt eine elektronenmikroskopische Aufnahme von Rasterpunkten eines Flexoklischees gemäß V5. Die Rasterpunkte entsprechen einem Tonwert von 2% bei 146 Ipi (lines per inch, *Zeilen pro Zoll*)*.*
Figur 2 zeigt eine elektronenmikroskopische Aufnahme von Rasterpunkten eines Flexoklischees gemäß V5. Die gezeigten Rasterpunkte entsprechen einem Tonwert von 30% bei 146 Ipi (lines per inch, *Zeilen pro Zoll*)*.*
Figur 3 zeigt eine elektronenmikroskopische Aufnahme einer Vollfläche eines Flexoklischees gemäß V5.

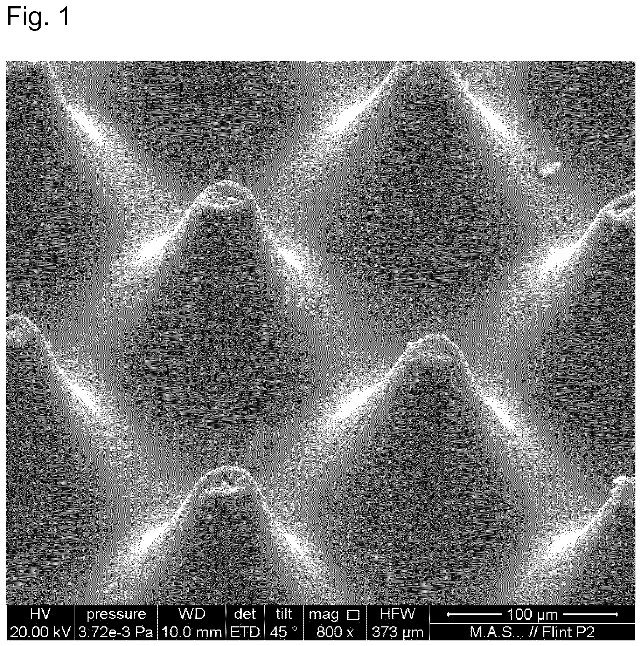

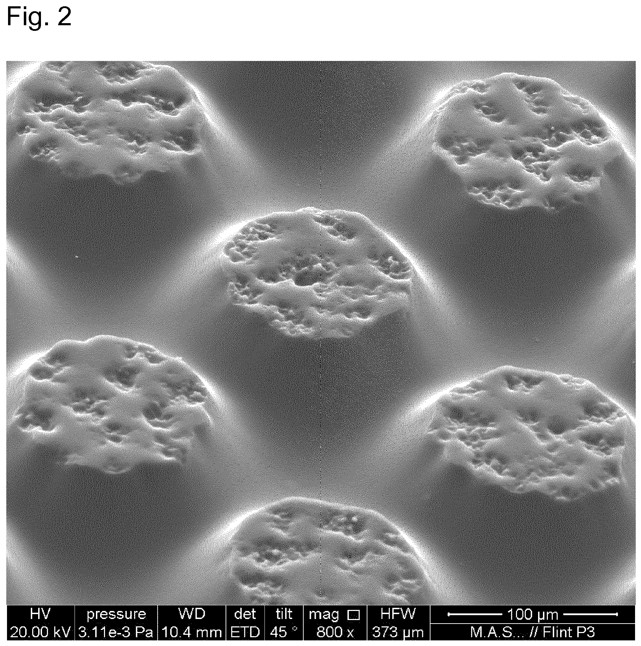

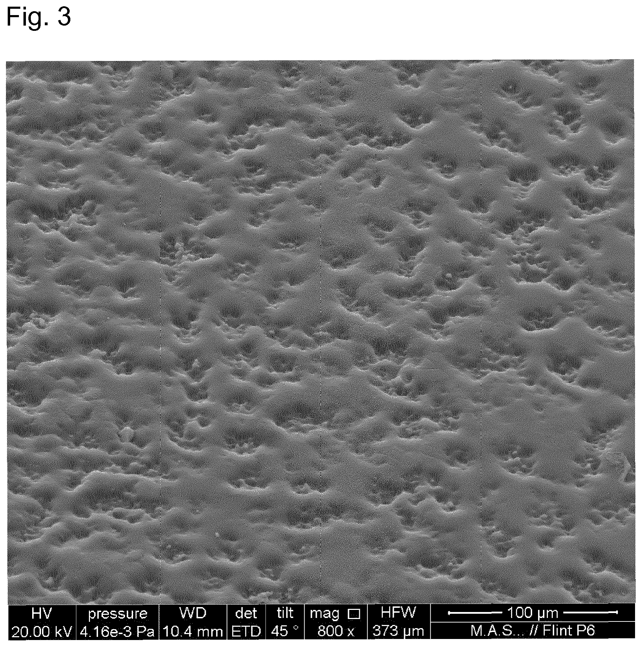

Die elektronenmikroskopischen Aufnahmen des Flexoklischees aus V5 (Figuren 1 bis 3) belegen eindrucksvoll, dass die Rauhigkeit der Barriereschicht auf die Oberfläche des Flexoklischees abgeformt wird. Die Oberfläche zeigt Vertiefungen bzw. Löcher, die für den verbesserten Farbübertrag verantwortlich sind. Die Rauhigkeit wird dabei nicht nur auf die flächigen Elemente des Flexoklischees übertragen (siehe Figur 3) sondern auch auf die Oberflächen der feinen Rasterpunkte (Figuren 1 und 2). Dies ist nur dadurch möglich, dass die Nachdiffusion von Sauerstoff durch die erfindungsgemäße Barriereschicht komplett unterbunden wird.

## Patentansprüche

1. Verfahren zur Herstellung einer Flexodruckform aus einem digital bebilderbaren, fotopolymerisierbaren Flexodruckelement enthaltend in der genannten Reihenfolge übereinander angeordnet mindestens
(A) einen dimensionsstabilen Träger,
(B) mindestens eine fotopolymerisierbare, reliefbildende Schicht mit einer Schichtdicke von 300 bis 7000 µm, umfassend mindestens ein elastomeres Bindemittel, ein ethylenisch ungesättigtes Monomer sowie einen Fotoinitiator oder ein Fotoinitiatorsystem,
(C) eine für UVA-Licht transparente, Sauerstoff-sperrende Barriereschicht mit einer Schichtdicke von 0,3 bis 5 µm,
(D) eine laserablatierbare Maskenschicht mit einer Schichtdicke von 0,3 bis 5 µm, umfassend mindestens ein elastomeres Bindemittel und ein UV/VIS-Licht absorbierendes Material, sowie
(E) eine abziehbare Deckfolie
das Verfahren umfassend die Verfahrensschritte (i) bis (v):
(i) Abziehen der Deckfolie (E),
(ii) Einschreiben einer Maske in die laserablatierbare Maskenschicht (D) mithilfe eines IR-Lasers,
(iii) Belichten des bebilderten Flexodruckelements mit UVA-Licht durch die gebildete Maske hindurch,
(iv) Entfernen der Reste der laserablatierbaren Maskenschicht (D), der Barriereschicht (C) sowie der nicht polymerisierten Anteile der reliefbildenden Schicht (B), sowie
(v) optional Nachbelichtung der getrockneten Flexodruckplatte mit UVA- und/oder UVC-Licht
**dadurch gekennzeichnet, dass**
- die Schichten (B), (C) und (D) in einem organischen Lösemittel löslich oder dispergierbar sind, und
- die Barriereschicht (C) mindestens ein Sauerstoff-sperrendes Bindemittel und eine oligomere oder polymere basische Haftkomponente enthält und dass
das mindestens teilweise Entfernen gemäß Schritt (iv) durch Erwärmen und Entfernen der nicht belichteten Bereiche mittels eines Entwicklungsmaterials erfolgt.

2. Verfahren nach Anspruch 1, **dadurch gekennzeichnet, dass** vor und/oder nach Schritt (ii) eine Belichtung des Flexodruckelements durch den Träger erfolgt, um einen Reliefgrund einzustellen.

3. Verfahren nach Anspruch 1 oder 2, **dadurch gekennzeichnet, dass** das Sauerstoff-sperrende Bindemittel der Barriereschicht (C) ein teilverseiftes Polyvinylacetat mit einem Verseifungsgrad von 10 bis 75 mol-% enthält.

4. Verfahren nach einem der Ansprüche 1 bis 3, **dadurch gekennzeichnet, dass** das Sauerstoff-sperrende Bindemittel der Barriereschicht (C) ein Polyvinylacetal enthält.

5. Verfahren nach einem der Ansprüche 1 bis 4, **dadurch gekennzeichnet, dass** das Polyvinylacetal ausgewählt ist aus der Gruppe bestehend aus Polyvinylformal, Polyvinylethyral, Polyvinylpropyral, Polyvinylbutyral und Poly(vinylethyral-vinylbutyral).

6. Verfahren nach einem der Ansprüche 1 bis 5, **dadurch gekennzeichnet, dass** die basische Haftkomponente der Barriereschicht (C) ein oligomeres oder polymeres Polyvinylamin oder Polyethylenimin ist.

7. Verfahren nach einem der Ansprüche 1 bis 5, **dadurch gekennzeichnet, dass** die Barriereschicht (C) zusätzlich einen Füllstoff enthält.

8. Verfahren nach Anspruch 7, **dadurch gekennzeichnet, dass** der Füllstoff eine mittlere Teilchengröße von 1 bis 10 µm, bevorzugt von 2 bis 6 µm aufweist.

9. Verfahren nach Anspruch 7 oder 8, **dadurch gekennzeichnet, dass** der Füllstoff SiO₂ oder ein Silikat ist.

10. Verfahren nach einem der Ansprüche 7 bis 9, **dadurch gekennzeichnet, dass** der Füllstoff oberflächenbehandelt oder oberflächenfunktionalisiert ist.

11. Verfahren nach einem der Ansprüche 1 bis 10, **dadurch gekennzeichnet, dass** die Sauerstoff-sperrende Barriereschicht (C)
50 bis 99 Gew.-% des Sauerstoff-sperrenden Bindemittels,
1 bis 30 Gew.-% der basischen Haftkomponente, und
0 bis 50 Gew.-% Füllstoffe
enthält.

12. Verfahren nach einem der Ansprüche 1 bis 11, **dadurch gekennzeichnet, dass** die Sauerstoff-sperrende Barriereschicht (C) 1 bis 30 Gew.-% Füllstoffe enthält.

13. Verfahren nach einem der Ansprüche 1 bis 12, **dadurch gekennzeichnet, dass** das elastomere Bindemittel der laserablatierbaren Maskenschicht (D) ausgewählt ist aus der Gruppe bestehend aus Polyamiden, Polyvinylacetaten, Ethylen-Vinylacetat-Copolymeren, teilverseiften Polyvinylacetaten, Polyurethanen, Nitrocellulose und Polyvinylacetalen.

14. Verfahren nach einem der Ansprüche 1 bis 13, **dadurch gekennzeichnet, dass** das UV-VIS-Licht absorbierende Material der Maskenschicht (D) ausgewählt ist aus der Gruppe bestehend aus Ruß, Graphit, Kohlenstoff-Nanopartikeln und Kohlenstoff-Nanoröhrchen.

15. Verfahren nach einem der Ansprüche 7 bis 14, **dadurch gekennzeichnet, dass** die Oberfläche der entwickelten Flexodruckform Füllstoffpartikel oder Vertiefungen aufweist.
